# EUROPEAN PATENT APPLICATION

(11) **EP 4 227 979 A1**
(43) Date of publication of application: **16.08.2023**
(21) Application number: 21946241.3
(22) Date of filing: 28.12.2021

(54) **BONDING SYSTEM AND BONDING METHOD**

(30) Priority: 24.12.2021 CN 202111594258
(71) Applicant: HUBEI 3D SEMICONDUCTOR INTEGRATED INNOVATION CENTER CO., LTD., Wuhan, Hubei 430000 (CN)
(72) Inventor: TIAN, Yingchao, Wuhan, Hubei 430000 (CN); LIU, Tianjian, Wuhan, Hubei 430000 (CN); CAO, Ruixia, Wuhan, Hubei 430000 (CN); WANG, Song, Wuhan, Hubei 430000 (CN)
(74) Representative: Gevers Patents
(86) International application number: PCT/CN2021/142026
(87) International publication number: WO 2023/115612

(57) **Abstract**

Embodiments of the present disclosure provide a bonding system and a bonding method. The bonding system includes a bonding assembly, a wafer stage, a first alignment assembly and a second alignment assembly. The wafer stage is configured to drive, according to a first deviation value determined by the first alignment assembly and a second deviation value determined by the second alignment assembly, a carried wafer to move so as to align a second die with a first die. The bonding assembly is configured to bond the first die to the second die. The bonding system further includes a third alignment assembly located at a side of the wafer stage away from the bonding assembly, and configured to determine a third deviation value between positions of the first die and the second die which have been bonded. The bonding assembly is further configured to debond the first die from the second die, in response to that the third deviation value is greater than a preset threshold.

## Description

### CROSS-REFERENCE TO RELATED APPLICATIONS

This application is based on and claims priority to Chinese Patent Application No. 202111594258.5 filed on December 24, 2021 and entitled "BONDING SYSTEM AND BONDING METHOD", the disclosure of which is hereby incorporated by reference in its entirety.

### TECHNICAL FIELD

Embodiments of the present disclosure relate to a bonding system and a bonding method.

### BACKGROUND

In the field of semiconductor manufacturing, three-dimensional (3D) integration of semiconductor devices may be implemented by using bonding technologies. Performance of chips may be improved by bonding two or more semiconductor structures with the same or different functions. Furthermore, metal interconnection between to-be-bonded objects may also be greatly shortened, reducing heating, power consumption and delay.

Bonding processes may be distinguished by bonding objects, and include wafer to wafer bonding, die to wafer bonding and die to die bonding.

### SUMMARY

An embodiment of the present disclosure provides a bonding system, including a bonding assembly, a wafer stage, a first alignment assembly, a second alignment assembly, and a third alignment assembly.

The bonding assembly includes a bonding head configured to pick a first die and a first optical path passing through the bonding head, here a first end of the first optical path is located at a picking surface where the bonding head picks the first die.

The wafer stage is configured to carry a wafer.

The first alignment assembly is located at a second end of the first optical path, and is configured to determine a first deviation value between a current position of the first die and a first target position according to a detection optical signal transmitted in the first optical path.

The second alignment assembly is located at a side of the wafer stage away from the bonding assembly, and is configured to determine a second deviation value between a current position of a second die on the wafer and a second target position.

The wafer stage is further configured to drive, according to the first deviation value and the second deviation value, the carried wafer to move relative to the picking surface, to align the second die with the first die.

The bonding assembly is further configured to bond the first die to the second die.

The third alignment assembly is located at the side of the wafer stage away from the bonding assembly, and is configured to determine a third deviation value between positions of the first die and the second die which have been bonded.

The bonding assembly is further configured to debond the first die from the second die, in response to that the third deviation value is greater than a preset threshold.

In some embodiments, the third alignment assembly may be located at a position adjacent to the second alignment assembly, here when a detection visual field of the second alignment assembly covers the second die, a detection visual field of the third alignment assembly covers a third die adjacent to the second die, the third die is a die which has been bonded on the wafer, and the third die and a fourth die have been bonded.

In some embodiments, the wafer stage may be further configured to move relative to the picking surface, in response to a fourth deviation value between positions of the third die and the fourth die greater than the preset threshold, to align the fourth die with the picking surface of the bonding assembly.

In some embodiments, the bonding assembly may be further configured to pick the fourth die when the fourth die is aligned with the picking surface, and to provide a pulling force to the fourth die to debond the fourth die from the third die.

In some embodiments, the bonding system may further include two sets of third alignment assemblies.

The two sets of third alignment assemblies are located at adjacent positions on both sides of the second alignment assembly respectively, here different third alignment assemblies are used when the bonding assembly performs bonding along a first direction of distributing dies on the wafer and when the bonding assembly performs bonding along a second direction of distributing dies on the wafer, and here the first direction and the second direction are opposite directions along a surface of the wafer.

In some embodiments, the third alignment assembly and the second alignment assembly may be composed of a same set of lens components.

The lens component is configured to determine the second deviation value before the first die is bonded to the second die, and to determine the third deviation value after the first die is bonded to the second die.

An embodiment of the present disclosure further provides a bonding method, including the following operations.

A first deviation value between a current position of a picked first die and a first target position is determined.

A second deviation value between a current position of a second die on a wafer and a second target position is determined.

The wafer is moved according to the first deviation value and the second deviation value, to align the first die with the second die.

The first die is bonded to the second die, after aligning the first die with the second die.

A third deviation value between positions of the first die and the second die which have been bonded is determined.

The first die is debonded from the second die, in response to that the third deviation value is greater than a preset threshold.

In some embodiments, the bonding method may further include the following operations after the first die is bonded to the second die.

The wafer is moved along a first direction, so that a next to-be-bonded die on the wafer and a picked next to-be-bonded die are located at opposite positions.

The operation of determining the third deviation value between positions of the first die and the second die which have been bonded is performed.

In some embodiments, debonding the first die from the second die, in response to that the third deviation value is greater than the preset threshold may include the following operations.

The wafer is moved along a second direction, in response to that the third deviation value is greater than the preset threshold, so that positions of the first die and the second die are located at a picking position, here the second direction is a direction opposite to the first direction, and the picking position is a corresponding position of a bonding head picking the first die.

The first die is debonded from the second die by using the bonding head picking the first die.

In some embodiments, the bonding method may further include the following operations.

A fourth deviation value between a position of a third die adjacent to the second die on the wafer and a position of a fourth die bonded on the third die is determined, when the first die and the second die are located at opposite positions.

The third die is debonded from the fourth die, in response to that the fourth deviation value is greater than the preset threshold.

Embodiments of the present disclosure provide a bonding system and a bonding method. In the bonding system, the first deviation value between the current position of the first die and the first target position may be determined by providing the first alignment assembly, the second deviation value between the current position of the second die on the wafer and the second target position may be determined by providing the second alignment assembly, the third deviation value between positions of the first die and the second die which have been bonded may be determined by providing the third alignment assembly, and the first die is debonded from the second die, in response to that the third deviation value is greater than the preset threshold. In this way, it is convenient to timely rework dies with abnormal bonding, to improve yield rate of die to wafer bonding.

### BRIEF DESCRIPTION OF THE DRAWINGS

One or more embodiments are exemplarily explained by pictures in the drawings corresponding thereto. Unless otherwise stated, the pictures in the drawings do not constitute scale limitation.
FIG. 1 shows a schematic view of die to wafer according to an embodiment of the present disclosure.
FIG. 2A shows a first schematic view of a bonding system according to an embodiment of the present disclosure.
FIG. 2B shows a schematic view of a part of a bonding system according to an embodiment of the present disclosure.
FIG. 2C shows a second schematic view of a bonding system according to an embodiment of the present disclosure.
FIG. 2D shows a third schematic view of a bonding system according to an embodiment of the present disclosure.
FIG. 2E shows a fourth schematic view of a bonding system according to an embodiment of the present disclosure.
FIG. 2F shows a fifth schematic view of a bonding system according to an embodiment of the present disclosure.
FIG. 3 shows a sixth schematic view of a bonding system according to an embodiment of the present disclosure.
FIG. 4 shows a seventh schematic view of a bonding system according to an embodiment of the present disclosure.
FIG. 5 shows an eighth schematic view of a bonding system according to an embodiment of the present disclosure.
FIG. 6 shows a ninth schematic view of a bonding system according to an embodiment of the present disclosure.
FIG. 7 shows a tenth schematic view of a bonding system according to an embodiment of the present disclosure.
FIG. 8 shows a schematic flowchart of a bonding method according to an embodiment of the present disclosure.
FIG. 9A shows a first schematic view of a structure corresponding to a bonding method according to an embodiment of the present disclosure.
FIG. 9B shows a second schematic view of a structure corresponding to a bonding method according to an embodiment of the present disclosure.
FIG. 9C shows a third schematic view of a structure corresponding to a bonding method according to an embodiment of the present disclosure.
FIG. 9D shows a fourth schematic view of a structure corresponding to a bonding method according to an embodiment of the present disclosure.

Reference numerals:
10 - Die; 20 - Wafer; 11 - First die; 21 - Second die; 301 - Bonding head; 301a - Top surface; 301b - Picking surface; 302 - First optical path; 302a - First end of first optical path; 302b - Second end of first optical path; 3021 - First reflector; 303 - Wafer stage; 304 - First alignment assembly; 3041 - Aligner; 3042 - Second optical path; 305 - Second alignment assembly; 306 - Third alignment assembly; 307 - Fixation unit; 308 - Mobile unit; 110 - First positioning mark; 110a - Shielding portion of first positioning mark; 110b - Transmitting portion of first positioning mark; 210 - Second positioning mark; 210a - Shielding portion of second positioning mark; 210b - Transmitting portion of second positioning mark; 31 - Third die; 41 - Fourth die; 51 - Next to-be-bonded die.

### DETAILED DESCRIPTION

Technical solutions of the present disclosure will be further described in detail below in combination with the drawings and embodiments. Although exemplary embodiments of the present disclosure are shown in the drawings, it should be understood that the present disclosure may be implemented in various forms and should not be limited by implementations described here. Instead, these implementations are provided to understand the present disclosure more thoroughly and convey the scope of the present disclosure to those skilled in the art completely.

In the following paragraphs, the present disclosure is described more specifically by way of example with reference to the drawings. According to the following descriptions and claims, advantages and features of the present disclosure will be clearer. It should be noted that the drawings are in a very simplified form and use imprecise scales, which are only intended to assistant to explain the embodiments of the present disclosure conveniently and clearly.

In the embodiments of the present disclosure, terms "first", "second" or the like are intended to distinguish similar objects, rather than describing a specific order or sequence.

It should be noted that the technical solutions recorded in the embodiments of the present disclosure may be arbitrarily combined with each other without conflict.

In the field of semiconductor manufacturing, as a rising bonding technology, hybrid bonding gradually transfers a bonding process from back end packaging to front end wafer manufacturing, and has many advantages over bump bonding of the back end packaging, such as simple process, smaller size, higher I/O density, non-existence of a problem of electro-migration failure, or the like. Hybrid bonding is more suitable to manufacture chips with high energy consumption and high bandwidth, such as High Bandwidth Memory (HBM), Neural-network Processing Unit (NPU), Artificial Intelligence (AI) chips, or the like.

Basic procedures of a hybrid bonding process are cleaning, plasma activation, hybrid bonding and annealing. Generally, bonding interfaces are connected by Van Der Waals force before annealing. When abnormal bonding (such as displacement deviation) is detected, debonding operation and subsequent reworking may be performed. However, the bonding interfaces are connected by covalent bonds after annealing. When debonding is performed again, the bonding interfaces may be damaged directly, leading to failure of products.

In a wafer to wafer hybrid bonding process, as a wafer is a whole piece, it is relatively easy to detect abnormal bonding and perform debonding. However, in a die to wafer hybrid bonding process, a wafer is cut into hundreds of die. When all dies are bonded and then detection and reworking are performed, bonding takes a long time, and activation of reworked bonding interfaces has been failed. On the other hand, there are a large number of dies, redetection takes a long time, and thus has a low economic benefit.

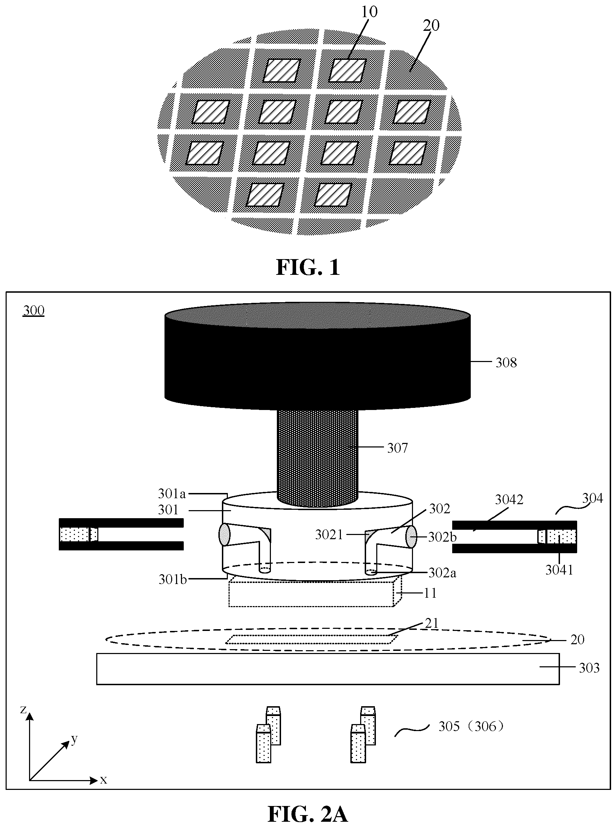

Exemplarily, FIG. 1 shows a schematic view of a die to wafer bonding structure. With reference to FIG. 1, multiple dies 10 are sequentially bonded to corresponding positions on a wafer 20. The multiple dies 10 may be of the same type, that is, all of them are memory chips, control chips or other chips of the same type. In this way, a plasma activation operation may be performed uniformly before a hybrid bonding process is performed.

Specifically, multiple dies of the same type (such as memory chips) are placed in a plasma atmosphere to activate chip surfaces, so as to facilitate subsequent connection with atoms on a wafer surface by Van Der Waals force. Exemplarily, the plasma atmosphere here may be provided by a plasma activator. As an effect of plasma activation is related to factors such as layout of the chip surface, type of the chip, or the like, multiple dies may be effectively activated in a single batch by using dies of the same type, to improve bonding efficiency.

It may be understood that FIG. 1 shows only a part of a bonding structure from the die 10 to the wafer 20. In an actual bonding operation, the number of dies which are activated by plasma in a single batch and on which the bonding operation is performed may be much larger than that of dies shown in FIG. 1. Furthermore, after currently activated dies are bonded to corresponding positions on the wafer 20, a next batch and type of dies (such as control chips) may be continued to be activated and bonded to the wafer.

On the other hand, with reference to FIG. 1, after the bonding operation is completed, it is possible to detect whether abnormal bonding occurs to a die on which the bonding operation has been completed. When it is detected that abnormal bonding such as displacement deviation, local damage or the like occurs to the die, debonding operation is performed to rework the die. For example, the die with displacement deviation requires position compensation, realignment and bonding, and the damaged dies are required to be replaced and re-bonded. Here, the present disclosure does not make too much limitation thereto.

Furthermore, when reworking is performed after bonding of the die is completed, since there are a large number of dies to be bonded, bonding takes a long time, and activation of reworked bonding interfaces has been failed. On the other hand, detection takes a long time, thus bonding efficiency is low, and economic benefit is low too.

In view of this, the embodiments of the present disclosure provide a bonding system and a bonding method.

FIG. 2A to FIG. 2F show a first schematic view of a bonding system 300 according to an embodiment of the present disclosure. With reference to FIG. 2A, the bonding system 300 includes a bonding assembly, a wafer stage 303, a first alignment assembly 304, a second alignment assembly 305, and a third alignment assembly 306.

The bonding assembly includes a bonding head 301 configured to pick a first die 11 and a first optical path 302 passing through the bonding head 301, here a first end 302a of the first optical path 302 is located at a picking surface 301b where the bonding head 301 picks the first die 11.

The wafer stage 303 is configured to carry a wafer 20.

The first alignment assembly 304 is located at a second end 302b of the first optical path 302, and is configured to determine a first deviation value between a current position of the first die 11 and a first target position according to a detection optical signal transmitted in the first optical path 302.

The second alignment assembly 305 is located at a side of the wafer stage 303 away from the bonding assembly, and is configured to determine a second deviation value between a current position of a second die 21 on the wafer 20 and a second target position.

The wafer stage 303 is further configured to drive, according to the first deviation value and the second deviation value, the carried wafer 20 to move relative to the picking surface 301b, to align the second die 21 with the first die 11.

The bonding assembly is further configured to bond the first die 11 to the second die 21.

The third alignment assembly 306 is located at the side of the wafer stage 303 away from the bonding assembly, and is configured to determine a third deviation value between positions of the first die 11 and the second die 21 which have been bonded.

The bonding assembly is further configured to debond the first die 11 from the second die 21, in response to that the third deviation value is greater than a preset threshold.

In the embodiment of the present disclosure, the bonding head 301 may have a cylindrical structure in FIG. 2A, and correspondingly, each of the picking surface 301b and a top surface 301a may have a circular shape. The first optical path 302 is located inside the cylindrical structure, and then passes through the bonding head 301, so that the first end 302a and the second end 302b of the first optical path 302 may be located on a surface of the bonding head 301.

The first optical path 302 includes the first end 302a and the second end 302b. The first end 302a is configured to output a detection optical signal and receive a reflection optical signal, and the second end 302b is configured to receive the detection optical signal and output the reflection optical signal. The first optical path 302 allows the detection optical signal and reflection optical signal to pass through, and may be a transparent window arranged in the bonding head 301, or an optical transmission medium arranged in the bonding head 301, such as an optical fiber, a waveguide, or the like.

A first reflector 3021 is included inside the first optical path 302. The first reflector 3021 is located between the first end 302a of the first optical path 302 and the second end 302b of the first optical path 302, and is configured to reflect the detection optical signal received by the second end 302b of the first optical path 302 to the first end 302a of the first optical path 302, and is further configured to reflect the reflection optical signal received by the first end 302a of the first optical path 302 to the second end 302b of the first optical path 302.

It should be noted that in some other embodiments, the first optical path 302 may directly pass through the bonding head 301 along a z direction in FIG. 2A, that is, a direction perpendicular to the picking surface 301b and the top surface 301a. Then the second end 302b of the first optical path 302 is correspondingly arranged on the top surface 301a of the bonding head 301, so that the first optical path 302 may not be provided with the first reflector 3021.

The bonding head 301 may adsorb the first die 11 by vacuum adsorption or electrostatic adsorption. The first die 11 may include a bonding surface and a non-bonding surface arranged opposite to each other. During die to wafer bonding, the picking surface 301b picks the first die 11 by adsorbing the non-bonding surface of the first die 11.

The first die 11 includes semiconductor chips, such as memory chips, communication chips, AI chips, light-emitting diode (LED) chips, sensor chips, display chips, or the like. With reference to FIG. 2A, the first die 11 includes a front side and a back side arranged opposite to each other in the z direction. When the front side of the first die 11 is provided with functional structures, the front side of the first die 11 is the bonding surface, and the back side of the first die 11 is the non-bonding surface.

It should be emphasized that the first die 11, the wafer 20 and the second die 21 are not included in the bonding system 300, and the first die 11, the wafer 20 and the second die 21 (shown in dash lines) are merely illustrative in FIG. 2A, to facilitate understanding position relationships among the to-be-bonded die, the bonding head and the wafer during die to wafer bonding.

In some embodiments, the bonding assembly also includes a fixation unit 307 and a mobile unit 308. The fixation unit 307 fixedly connects the top surface 301a of the bonding head 301 to the mobile unit 308. The mobile unit 308 is configured to move the bonding head 301 relative to the wafer stage 303.

The wafer stage 303 may include a chuck (not shown in the figure), such as an electrostatic chuck (ESC chuck), to adsorb the wafer 20.

In some embodiments, a mesa of the wafer stage 303 configured to carry the wafer 20 is not movable itself, however, the wafer stage 303 includes a lift pin which may move relative to the picking surface 301b. The wafer 20 may be driven to move relative to the picking surface 301b by driving the lift pin to move relative to the picking surface 301b, to implement position adjustment of the wafer 20. The lift pin may be provided with a vacuum hole to absorb the wafer through vacuum. The lift pin may move in a plane parallel to the wafer 20, to drive the wafer 20 to move, so as to adjust the position of the wafer 20.

Specifically, the wafer stage 303 including the ESC chuck is taken as an example, the ESC chuck includes a fixed substrate and a lift pin, the lift pin passes through the fixed substrate in an axial direction of the ESC chuck and may move in a direction perpendicular to the fixed substrate and a direction parallel to the fixed substrate. When the ESC chuck carries a wafer 20, the lift pin may contact the wafer 20. When the lift pin moves towards the picking surface 301b in the direction perpendicular to the fixed substrate, the carried wafer 20 is jacked up by the lift pin and thus separated from the fixed substrate, and the carried wafer 20 moves with the lift pin.

The wafer 20 includes multiple second dies 21, each of the second dies 21 includes a substrate and functional structures (such as a storage array or a functional circuit) on the substrate, and a cutting channel is arranged between two adjacent second dies 21.

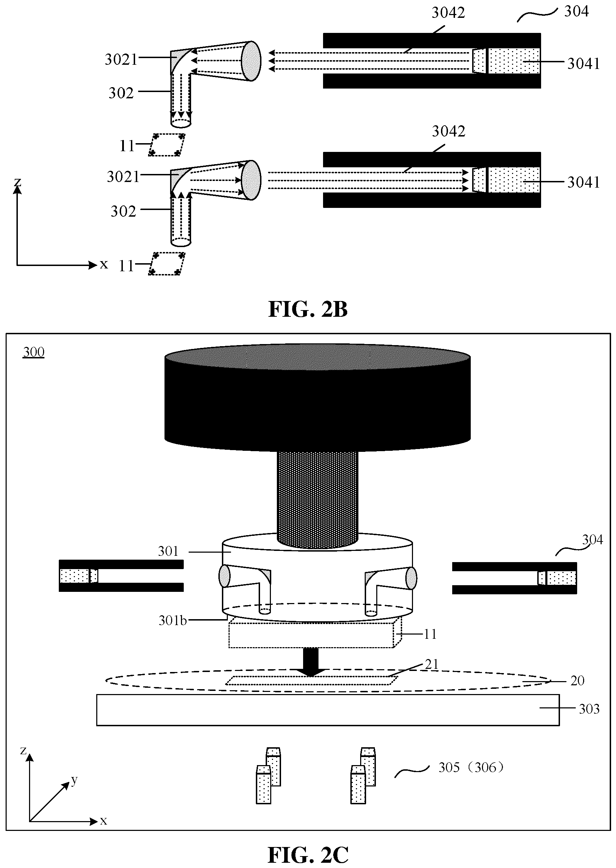

With reference to FIG. 2B, the first alignment assembly 304 may include an aligner 3041 and a second optical path 3042, here the aligner 3041 is configured to transmit a detection optical signal, receive a reflection optical signal, and determine the first deviation value between the current position of the first die 11 and the first target position. Exemplarily, when the bonding assembly is located at a first position, the aligner 3041 transmits a detection optical signal which is transmitted to a positioning mark (shown by "+" in FIG. 2B) of the first die 11 through the second optical path 3042 and the first optical path 302 to form a reflection optical signal, the reflection optical signal is transmitted back to the aligner 3041 through the first optical path 302 and the second optical path 3042.

The first alignment assembly 304 involved in the embodiments of the present disclosure is located at a side of the wafer stage 303 opposite to the bonding assembly, and determines the first deviation value by the detection optical signal and the reflection optical signal. In contrast, as shown in FIG. 2A, the second alignment assembly 305 and the third alignment assembly 306 are located at a side of the wafer stage 303 facing the bonding assembly, i.e., the side of the wafer stage 303 away from the bonding assembly. It may be understood that the second alignment assembly 305 and the third alignment assembly 306 involved in the embodiments of the present disclosure may be a same set of alignment assemblies or two independent sets of alignment assemblies.

Specifically, the second alignment assembly 305 may determine the second deviation value between the current position of the second die 21 and the second target position, according to a positioning mark of the second die 21 on the wafer 20, and the third alignment assembly 306 may determine the third deviation value according to positioning marks on the first die 11 and the second die 21 which have been bonded.

Exemplarily, with reference to FIG. 2A, after the bonding head 301 of the bonding assembly picks the first die 11, the bonding assembly may move in a horizontal direction (e.g., x direction or y direction) to adjust the bonding assembly to the first position. Here, the first position represents a position where the second end 302b of the first optical path 302 may receive the detection optical signal transmitted by the first alignment assembly 304.

Exemplarily, with reference to FIG. 2A and FIG. 2B, the first alignment assembly 304 transmits the detection optical signal when the bonding assembly is located at the first position, the detection optical signal is transmitted to the positioning mark of the first die 11 through the second end 302b and the first end 302a of the first optical path 302. Here, the positioning mark may be a patterned structure composed of a metal material or another reflective material, so that the detection optical signal forms a reflection optical signal on a surface of the positioning mark, the reflection optical signal is transmitted back to the first alignment assembly 304 through the first end 302a and the second end 302b of the first optical path 302.

Exemplarily, after receiving the reflection optical signal, the first alignment assembly 304 may determine the first deviation value (Δx_{T}, Δy_{T}) between the current position (x₁, y₁) of the first die 11 and the first target position (x₀, y₀) according to the reflection optical signal, here Δx_{T} = x₁ - x₀, Δy_{T} = y₁ - y₀. It should be noted that the first deviation value is obtained through optical alignment and is a displacement deviation in the horizontal direction, and values Δx_{T} and Δy_{T} does not represent coordinate values, instead, represent distances between coordinate points of the first die 11 on x-axis and y-axis respectively and coordinate points corresponding to the first target position, and the values may be positive or negative results, here "positive" and "negative" represent a direction. For example, when Δx_{T} in the first deviation value is a positive result, it means that coordinate of the first die 11 on the x-axis is located in a positive direction of the first target position along the x-axis, with a distance of an absolute value of Δx_{T}; vice versa, when Δx_{T} in the first deviation value is a negative result, it means that coordinate of the first die 11 on the x-axis is located in a negative direction of the first target position along the x-axis, with a distance of an absolute value of Δx_{T} too.

Exemplarily, with reference to FIG. 2A, the second deviation value (Δx_{B}, Δy_{B}) between the current position (x₂, y₂) of the second die 21 on the wafer 20 and the second target position (x₀', y₀') may be determined by using the second alignment assembly 305, here Δx_{B} = x₂ - x₀', Δy_{T} = y₂ - y₀'. It may be understood that the second deviation value is also a displacement deviation in the horizontal direction, and values Δx_{B} and Δy_{B} have meanings the same as those of corresponding values in the first deviation value.

It should be pointed out that the first target position and the second target position have the same position in the horizontal direction, while have different positions in a vertical direction, that is, x₀ is the same as x₀', y₀ is the same as y₀', and the first target position and the second target position have different coordinates in the z direction. Different reference numerals are only intended to facilitate distinction between the first target position and the second target position, and are not intended to limit the present disclosure.

Furthermore, before die to wafer bonding, a standard die may be used to calibrate positions of the first alignment assembly, the second alignment assembly and the bonding assembly, to ensure that the first alignment assembly may be aligned with the second end of the first optical path, and that the second alignment assembly may be aligned with a positioning mark on a surface of the standard die facing the wafer stage, thus determining the first target position and the second target position. Here, the first target position represents a position of the standard die after calibration, and coordinate in the horizontal direction is marked as (x₀, y₀); a position with a preset distance from the first target position in the vertical direction is marked as the second target position, coordinate of the second target position in the horizontal direction is marked as (x₀', y₀'), here the preset distance is greater than 0. It may be understood that although the first target position and the second target position have the same position in the horizontal direction (x and y directions), they are not the same position in a 3D space, that is, the first target position and the second target position have different positions in the vertical direction (z direction).

It may be understood that after calibration by the standard die, the first die 11 and the first target position are located in a same horizontal plane, and the second die 21 and the second target position are located in a same horizontal plane. Therefore, subsequent alignment operations may be performed according to the first deviation value (Δx_{T}, Δy_{T}) and the second deviation value (Δx_{B}, Δy_{B}).

Furthermore, when the first die 11 is located at the first target position, and the second die 21 is located at the second target position, it may be considered that the first die 11 is aligned with the second die 21. That is, a projection of the first die 11 on a surface of the wafer 20 overlaps with the second die 21 in the vertical direction.

It should be emphasized that the current position of the first die 11 represents an actual position of the first die 11 when the bonding assembly is adjusted to the first position, and may have a deviation with respect to the first target position. The current position of the second die 21 represents an actual position of the second die 21 when the wafer 20 is placed on the wafer stage 303 and a die required to be bonded on the wafer 20 is determined to be the second die 21, and may have a deviation with respect to the second target position.

When the current position of the first die 11 is the first target position and the current position of the second die 21 is the second target position, each of the first deviation value and the second deviation value is 0. Accurate alignment and bonding between the first die 11 and the second die 21 may be implemented by the wafer 20 vertically moving upward or the bonding head 301 vertically moving downward.

Exemplarily, when the bonding assembly is kept fixed (that is, the first die 11 is kept fixed), a displacement deviation between the first die 11 and the second die 21 may be determined to be (Δx_{T} - Δx_{B}, Δy_{T} - Δy_{B}) according to the first deviation value and the second deviation value. The wafer stage 303 drives the wafer 20 to move by (Δx_{T} - Δx_{B}, Δy_{T} - Δy_{B}) horizontally according to the displacement deviation, so that the first die 11 is aligned with the second die 21, that is, positions of the first die 11 and the second die 21 in the horizontal direction are the same.

Here, a direction in which the wafer stage 303 drives the wafer 20 to move may be determined according to a positive or negative value of Δx_{T} - Δx_{B}. For example, when Δx_{T} - Δx_{B} is a negative value, the wafer stage 303 drives the wafer 20 to move in a negative direction of x-axis, and a movement distance is an absolute value of (Δx_{T} - Δx_{B}). When Δx_{T} - Δx_{B} is a positive value, the wafer stage 303 drives the wafer 20 to move in a positive direction of x-axis, and a movement distance is (Δx_{T} - Δx_{B}).

Similarly, a direction in which the wafer stage 303 drives the wafer 20 to move may be determined according to a positive or negative value of Δy_{T} - Δy_{B}. For example, when Δy_{T} - Δy_{B} is a negative value, the wafer stage 303 drives the wafer 20 to move in a negative direction of y-axis, and a movement distance is an absolute value of (Δy_{T} - Δy_{B}). When Δy_{T} - Δy_{B} is a positive value, the wafer stage 303 drives the wafer 20 to move in a positive direction of y-axis, and a movement distance is (Δy_{T} - Δy_{B}).

In this example, the wafer stage 303 drives the wafer 20 to move relative to the picking surface 301b, however, in other examples, the bonding assembly may move relative to the wafer 20 to align the first die 11 with the second die 21. For example, the wafer 20 may be kept fixed (that is, the second die 21 is kept fixed), and the bonding assembly moves by (Δx_{T} - Δx_{B}, Δy_{T} - Δy_{B}) horizontally according to the displacement deviation, so that the first die 11 is aligned with the second die 21.

Here, a direction in which the bonding assembly moves may be determined according to a positive or negative value of Δx_{T} - Δx_{B}. For example, when Δx_{T} - Δx_{B} is a negative value, the bonding assembly moves in a positive direction of x-axis, and a movement distance is an absolute value of (Δx_{T} - Δx_{B}). When Δx_{T} - Δx_{B} is a positive value, the bonding assembly moves in a negative direction of x-axis, and a movement distance is (Δx_{T} - Δx_{B}).

Similarly, a direction in which the bonding assembly moves may be determined according to a positive or negative value of Δy_{T} - Δy_{B}. For example, when Δy_{T} - Δy_{B} is a negative value, the bonding assembly moves in a positive direction of y-axis, and a movement distance is an absolute value of (Δy_{T} - Δy_{B}). When Δy_{T} - Δy_{B} is a positive value, the bonding assembly moves in a negative direction of y-axis, and a movement distance is (Δy_{T} - Δy_{B}).

Exemplarily, with reference to FIG. 2C, after aligning the first die 11 with the second die 21, the bonding assembly may drive the bonding head 301 to vertically move downward in the z direction (as shown by an arrow in the figure), to perform the bonding operation.

In the embodiments of the present disclosure, the first alignment assembly 304, the second alignment assembly 305 and the third alignment assembly 306 are arranged outside the bonding assembly, which does not increase weight of the bonding assembly additionally and allows inertia of the bonding assembly to be small. Furthermore, it may ensure that the bonding assembly moves with high frequency and high accuracy in the vertical direction, improving bonding accuracy while improving bonding efficiency.

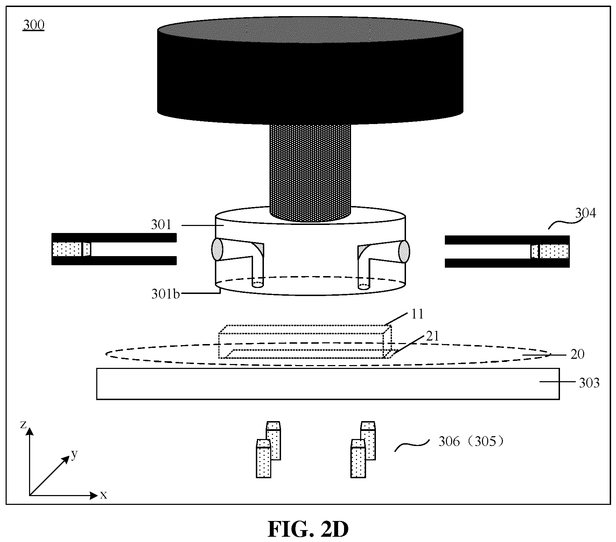

With reference to FIG. 2D, the first die 11 and the second die 21 which have been bonded are connected on a surface of the wafer 20 by Van Der Waals force. During bonding, the bonding head 301 moves in the vertical direction, which may generate a displacement deviation. Therefore, the third deviation value between positions of the first die 11 and the second die 21 which have been bonded may be determined by the third alignment assembly 306, and then it is determined whether the first die 11 and the second die 21 meet bonding requirements and are required to be reworked.

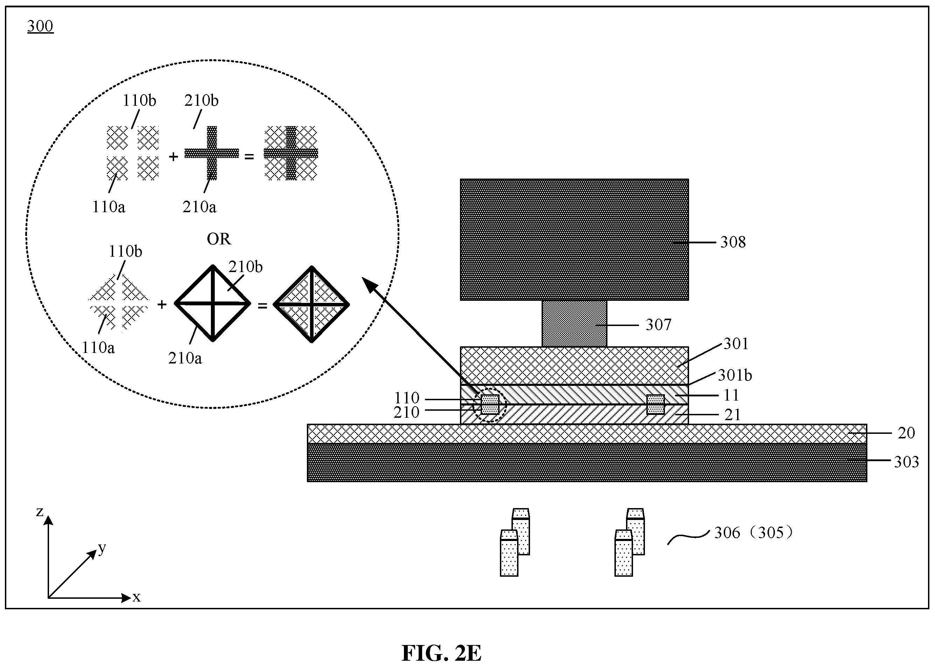

Exemplarily, FIG. 2D shows the first die 11 and the second die 21 on which the bonding operation is completed according to an embodiment of the present disclosure. With reference to FIG. 2E, positioning marks in the embodiment of the present disclosure include a first positioning mark 110 on the first die 11 and a second positioning mark 210 on the second die 21. Here, each of the first positioning mark 110 and the second positioning mark 210 may be a patterned structure and may be made of a metal material or another reflective material, so that the detection optical signal forms a reflection optical signal at the positioning marks.

The third alignment assembly 306 is located at a side of the wafer stage 303 facing the bonding assembly and may transmit a detection optical signal. Here, the detection optical signal may be infrared light transmitting silicon materials on the wafer 20, the first die 11 and the second die 21, but reflected by the positioning marks.

A reflection optical signal formed at the positioning marks is transmitted back to the third alignment assembly 306, so that a projection image between the first positioning mark 110 and the second positioning mark 210 is obtained. Here, the detection optical signal may be transmitted by an optical transmitter such as a LED, a laser diode, or the like, and the reflection optical signal may be received by a photodetector such as a photodiode, a photomultiplier tube, or the like. Furthermore, the photodetector may be connected to an image sensor configured to convert the received reflection optical signal into a visual projection image, according to which the third deviation value between positions of the first die 11 and the second die 21 may be determined. The optical transmitter and the photodetector may also be integrated in the same electronic device, the present disclosure does not make too much limitation thereto.

It may be understood that the wafer stage 303 may include a transparent window through which the detection optical signal transmitted by the third alignment assembly 306 is transmitted or which is located outside an optical path of the detection optical signal, so that the detection optical signal may irradiate onto a surface of the wafer 20 contacting the wafer stage 303.

Specifically, with reference to FIG. 2E, the first positioning mark 110 includes a shielding portion 110a and a transmitting portion 110b, and the second positioning mark 210 includes a shielding portion 210a and a transmitting portion 210b. The optical transmitter in the third alignment assembly transmits the detection optical signal and irradiates onto the second positioning mark 210. Among them, a part of the detection optical signal forms a transmission optical signal on the shielding portion 210a, and the remaining detection optical signal continues to irradiate onto the first positioning mark 110 by passing through the transmitting portion 210b.

Furthermore, the remaining detection optical signal forms a reflection optical signal on the shielding portion 110a of the first positioning mark 110. The reflection optical signal is transmitted, together with the transmission optical signal formed on the shielding portion 210a of the second positioning mark 210, back to the photodetector of the third alignment assembly 306. Finally, projection images corresponding to the first positioning mark 110 and the second positioning mark 210 are generated on the image sensor connected to the photodetector.

Here, when the projection image meets a preset pattern, it may be determined that the third deviation value is less than the preset threshold, and when the projection image does not meet the preset pattern, it may be determined that the third deviation value is greater than the preset threshold. FIG. 2E shows two possible forms of the first positioning mark 110, the second positioning mark 210 and the preset pattern.

The shielding portion 110a of the first positioning mark 110 having a "+" shape is taken as an example, the transmitting portion 210b of the second positioning mark 210 also has a "+" shape correspondingly. When center of the shielding portion 110a coincides with center of the transmitting portion 210b in the projection image, and distances between edges of the shielding portion 110a and edges of the transmitting portion 210b are equal, it is determined that the third deviation value is less than the preset threshold. On the contrary, it means that there is a horizontal displacement deviation between the first die 11 and the second die 21. Coordinate points in the projection image may determine the third deviation value. In response to that the third deviation value is greater than the preset threshold, it is required to debond and rework the first die 11, and re-perform the bonding operation.

A first projection of the transmitting portion 110b of the first positioning mark 110 and a second projection of the transmitting portion 210b of the second positioning mark 210 may be obtained on the bonding surface of the first die 11 with the second die 21. Furthermore, it may be determined whether bonding conditions are met between the first die 11 and the second die 21, by observing whether a pattern composed of the first projection and the second projection meets the preset pattern.

It may be understood that in FIG. 2E, the transmission portion 110a of the first positioning mark 110 may not correspond to the shielding portion 210a of the second positioning mark 210, and a solution of determining a relationship between magnitudes of the third deviation value and the preset threshold by the projection image should belong to the scope of protection of the present disclosure.

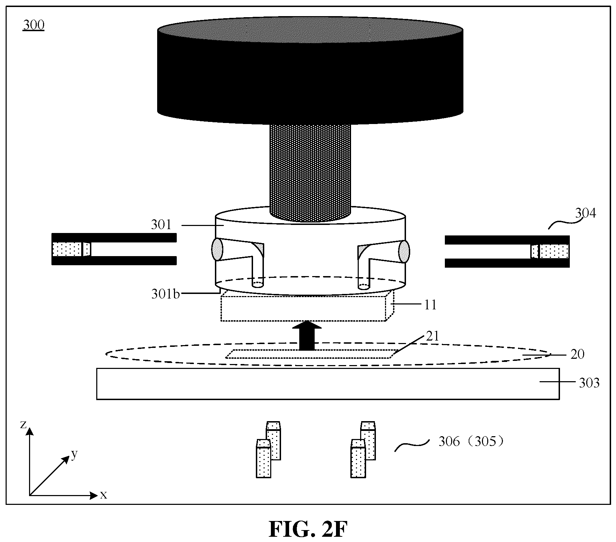

Furthermore, with reference to FIG. 2F, in response to that the third deviation value is greater than the preset threshold, the bonding assembly drives the bonding head 301 to re-pick the first die 11 and vertically move upward in a positive direction of z-axis (as shown by an arrow in the figure), to debond the first die 11 from the second die 21.

It should be pointed out that when the second alignment assembly 305 and the third alignment assembly 306 are the same set of alignment assemblies, operations of bonding, determining the third deviation value and debonding may be sequentially performed. When the second alignment assembly 305 and the third alignment assembly 306 are different sets of alignment assemblies, the wafer stage 303 is required to move to drive the wafer 20, so as to align the second die 21 with the third alignment assembly 306 and determine the third deviation value, after bonding the first die 11 to the second die 21. Synchronously, a next set of to-be-bonded dies may be bonded. When bonding of the next set of to-be-bonded dies is completed, and the third deviation value between the first die 11 and the second die 21 is greater than the preset threshold, debonding of the first die 11 from the second die 21 is performed.

In the embodiments of the present disclosure, the first deviation value between the current position of the first die 11 and the first target position may be determined by providing the first alignment assembly 304, the second deviation value between the current position of the second die 21 on the wafer and the second target position may be determined by providing the second alignment assembly 305, the third deviation value between positions of the first die 11 and the second die 21 which have been bonded may be determined by providing the third alignment assembly 306, and the first die 11 is debonded from the second die 21, in response to that the third deviation value is greater than the preset threshold. In this way, it is convenient to timely rework dies with abnormal bonding, to improve yield rate of die to wafer bonding.

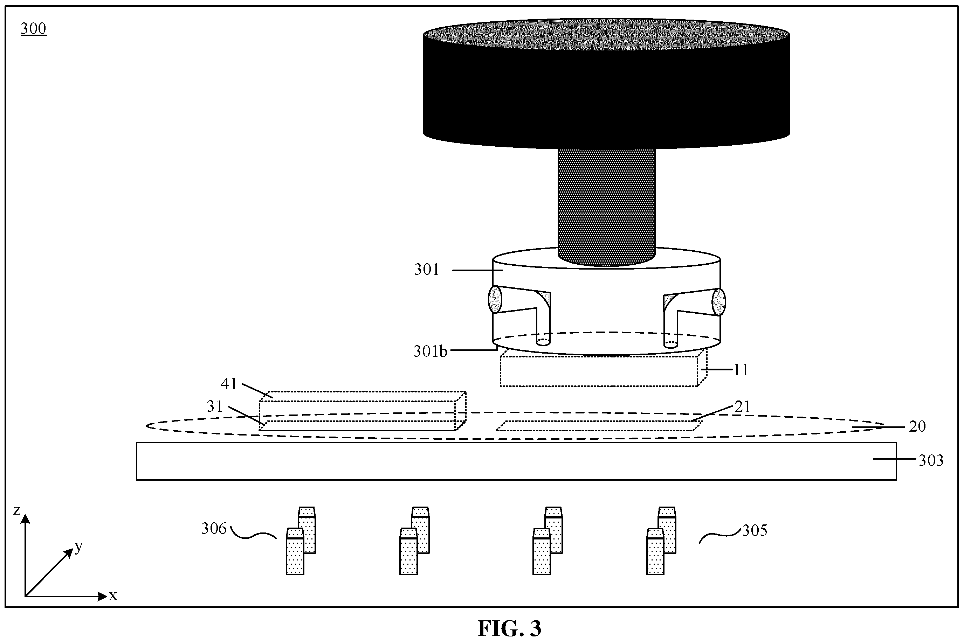

In some embodiments, with reference to FIG. 3, the third alignment assembly 306 is located at a position adjacent to the second alignment assembly 305, here when a detection visual field of the second alignment assembly 305 covers the second die 21, a detection visual field of the third alignment assembly 306 covers a third die 31 adjacent to the second die 21, the third die 31 is a die which has been bonded on the wafer, and the third die 31 and a fourth die 41 have been bonded.

In the embodiments of the present disclosure, die to wafer bonding includes the following operations. Multiple plasma activated dies with the same batch and same type are sequentially bonded to corresponding positions on the wafer 20. with reference to FIG. 3, during the operation of bonding the first die 11 to the second die 21, the third die 31 adjacent to the second die 21 in the x-axis direction has been bonded to the corresponding fourth die 41. Here, the third die 31 and the second die 21 are located on a bonding surface of the wafer 20, and are configured to achieve a hybrid bonding structure with external chips (such as the first die 11 and the fourth die 41). The fourth die 41 is a plasma activated die with the same type as the first die 11, and includes, but is not limited to semiconductor chips (such as memory chips, communication chips, or the like), AI chips, LED chips, sensor chips, display chips, or the like.

When the first die 11 is vertically moved downward in the z-axis direction by using the bonding head 301, a situation of bonding the third die 31 and the fourth die 41 may be detected synchronously. Specifically, the detection optical signal transmitted by the second alignment assembly 305 irradiates on the second die 21 to expose the corresponding second positioning mark 210 on the second die 21 to the detection visual field, so as to determine the second deviation value before bonding.

Correspondingly, the third alignment assembly 306 is adjacent to the second alignment assembly 305, the third die 31 is adjacent to the second die 21 and includes a third positioning mark. The corresponding third positioning mark on the third die 31 may be exposed to the detection visual field by irradiating the detection optical signal transmitted by the third alignment assembly 306 onto the third die 31, so as to determine the third deviation value after bonding.

It may be understood that the first positioning mark 110 on the first die 11 corresponds to the second positioning mark 210 on the second die 21, a fourth positioning mark on the fourth die 41 corresponds to the third positioning mark on the third die 31, and positioning marks on the first die 11 and the fourth die 41 may be the same or different. Here, it is only required to cover corresponding positioning marks within detection visual fields of the second alignment assembly 305 and the third alignment assembly 306 to determine the deviation value.

Exemplarily, when the first die 11 has a rectangular shape, the first positioning mark 110 may be located at four corners of the first die 11, and a patterned shape thereof may be "+", "L", diamond shape, or the like. The second positioning mark 210 is located on the second die 21. The detection optical signal transmitted by the second alignment assembly 305 covers the second positioning mark 210. The formed projection images of the second positioning mark 210 and the first positioning mark 110 may form a corresponding preset image.

Exemplarily, the fourth die 41 has a rectangular shape, the fourth positioning mark may also be located at four corners of the fourth die 41, and a patterned shape thereof may be the same as that of the first positioning mark 110. In this way, the detection optical signal transmitted by the third alignment assembly 306 covers the third positioning mark on the third die. The formed projection images of the third positioning mark and the fourth positioning mark may form a corresponding preset image, and the two preset images should be the same.

In this way, the third alignment assembly 306 adjacent to the second alignment assembly 305 may have the same structure as the second alignment assembly 305, that is, they have the same number of lenses, the same spacing between lenses, the same positions of lenses, or the like. Therefore functions of the second alignment assembly 305 and the third alignment assembly 306 may be replaced by each other.

Exemplarily, when the detection visual field of the third alignment assembly 306 covers the second die 21, the detection visual field of the second alignment assembly 305 covers the third die 31 adjacent to the second die 21, and the third die 31 and the fourth die 41 have been bonded.

It may be understood that in the embodiments of the present disclosure, the third alignment assembly 306 may be located at a position adjacent to the second alignment assembly 305 in the y-axis direction, or may include at least two alignment assemblies located at positions adjacent to the second alignment assembly 305 in the x-axis and y-axis directions respectively, which should be determined according to a die to wafer bonding sequence in an actual bonding process.

In the embodiments of the present disclosure, adjacent second alignment assembly 305 and third alignment assembly 306 are used, here a set of alignment assemblies is configured to align with a die on which the bonding operation is performed currently, and synchronously, another set of alignment assemblies is configured to detect a die on which bonding is completed. In this way, efficiency of detection and bonding is greatly improved, debonding may be performed timely, and dies which do not meet bonding conditions may be reworked to increase yield rate of products.

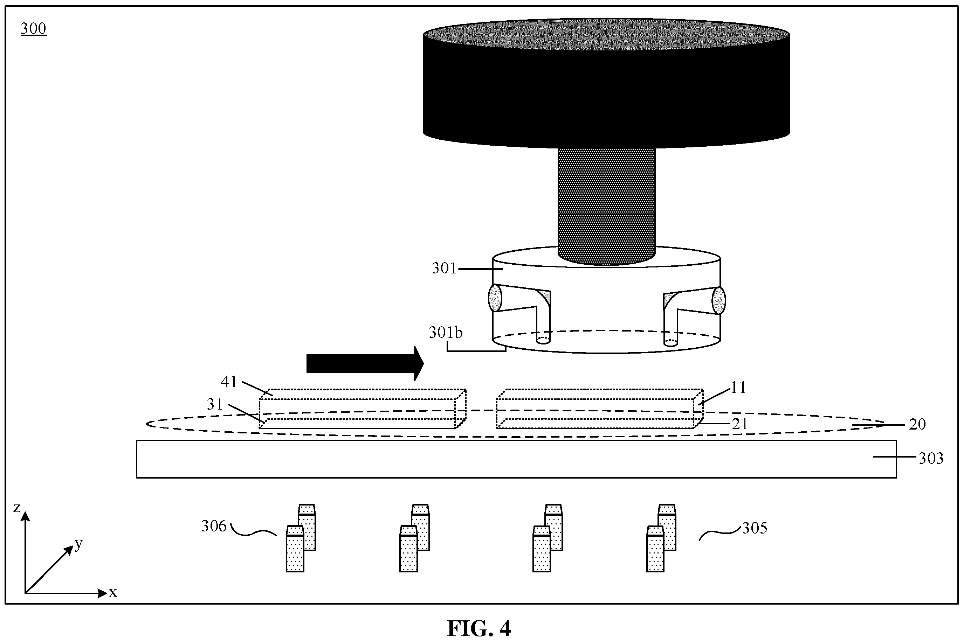

In some embodiments, with reference to FIG. 4, the wafer stage 303 is further configured to move relative to the picking surface 301b, in response to a fourth deviation value between positions of the third die 31 and the fourth die 41 greater than the preset threshold, to align the fourth die 41 with the picking surface 301b of the bonding assembly.

In the embodiments of the present disclosure, the alignment operation is performed by moving the wafer stage 303. Specifically, the wafer stage 303 is configured to drive, according to a horizontal offset of the first deviation value and the second deviation value, the carried wafer 20 to move relative to the picking surface 301b, to align the second die 21 with the first die 11. This is because in the embodiments of the present disclosure, the bonding head 301 has a small size, is easy to fluctuate, and may incline relative to a horizontal plane, leading to inclination of the die picked by the bonding head 301, affecting alignment and reducing bonding accuracy. Instead, the wafer 20 has a size greater than that of the bonding head 301, there is a small probability of the bonding surface of the wafer 20 fluctuating in the horizontal plane during the stage 303 driving the wafer 20 to move, that is, the second die 21 bonded with the first die 11 is more horizontal, which is conducive to improving accuracy of die to wafer bonding.

In the embodiments of the present disclosure, the bonding operation is performed by moving the bonding head 301. Specifically, the bonding assembly is configured to drive, according to a vertical distance between the first target position and the second target position, the bonding head 301 to vertically move downward to bond the first die 11 picked by the bonding head 301 to the second die 21 on the wafer 20. This is because the bonding head 301 has small size and mass compared with the wafer stage 303, the bonding head 301 has small inertia and may move with fast speed and high frequency, which is conducive to improving efficiency of die to wafer bonding.

Exemplarily, after bonding of the third die 31 and the fourth die 41 is completed, the fourth deviation value between positions of the third die 31 and the fourth die 41 is determined by the third alignment assembly 306. Here, the method for determining the fourth deviation value may be the same as the method for determining the third deviation value between positions of the first die 11 and the second die 21 in the above embodiments. That is, projections of the positioning marks on the third die 31 and the fourth die 41 are converted into visual images according to the reflection optical signal, and the fourth deviation value is determined according to position coordinates in the projection image.

In response to the fourth deviation value less than the preset threshold, it means that the third die 31 and the fourth die 41 meet bonding conditions, and reworking thereof is not required. In response to that the fourth deviation value is greater than the preset threshold, it means that there is a displacement deviation between the third die 31 and the fourth die 41, and reworking thereof is required. Here, reworking indicates that the third die 31 is debonded from the fourth die 41 when materials of surfaces of the dies are still in a plasma activated state, and the third die 31 is bonded to the fourth die 41 after re-aligning the third die 31 with the fourth die 41.

With reference to FIG. 4, After the current bonding operation is completed, that is, after the first die 11 is bonded to the second die 21, the bonding assembly is required to be lifted up to a certain height, to avoid contact between the bonding head 301 and the bonded dies when the wafer stage 303 drives the wafer 20 to move. Furthermore, after the bonding assembly drives the bonding head 301 to vertically move upward by a certain distance, the bonding head 301 is kept fixed, and the bonding assembly drives the wafer 20 to move relative to the picking surface 301b of the bonding head 301 in an arrow direction, so as to align, with the picking surface 301b, the fourth die 41 which has been bonded.

It may be understood that the bonding assembly, the first alignment assembly 304, the second alignment assembly 305 and the third alignment assembly 306 are kept fixed when the wafer stage 303 drives the wafer 20 to move. After movement of the wafer 20 is completed, the first alignment assembly 304 may be re-used to determine whether the fourth die 41 is aligned with the picking surface 301b.

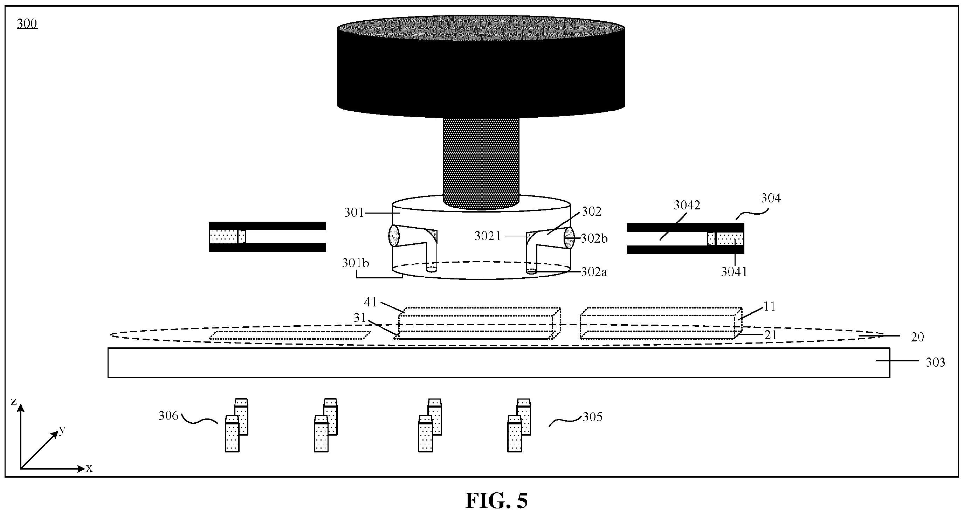

Exemplarily, with reference to FIG. 5, the first alignment assembly 304 transmits the detection optical signal by using the aligner 3041, the detection optical signal is transmitted to the first optical path 302 through the second optical path 3042, and is received from the second end 302b of the first optical path 302, with a direction of the optical path adjusted through the first reflector 3021, and the detection optical signal is transmitted from the first end 302a of the first optical path 302 to the positioning mark of the fourth die 41 (not shown in the figure), forming the reflection optical signal, Then the reflection optical signal is transmitted back to the aligner 3041 through the first optical path 302 and the second optical path 3042. When the fourth die 41 is located at the first target position, it means that the fourth die 41 is aligned with the picking surface 301b of the bonding head 301, and subsequent debonding operation may be performed.

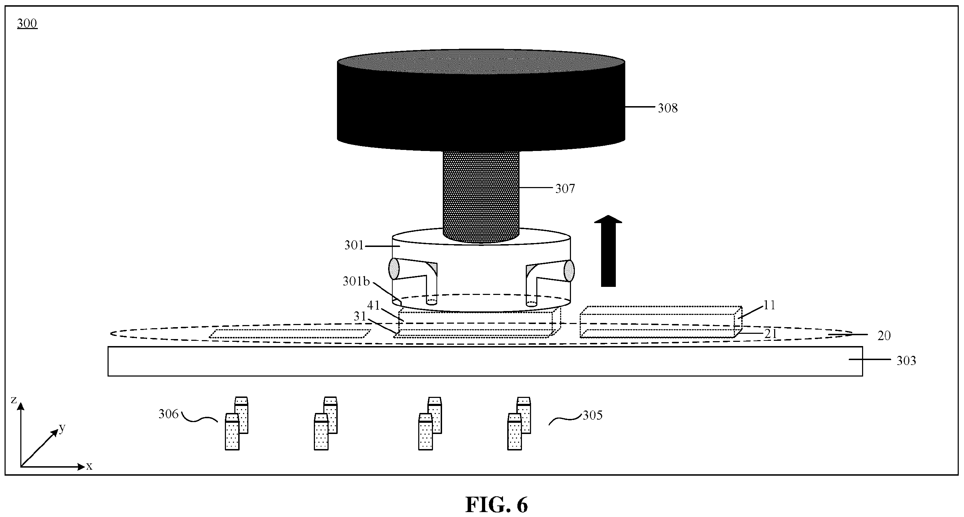

In some embodiments, with reference to FIG. 6, the bonding assembly is further configured to pick the fourth die 41 when the fourth die 41 is aligned with the picking surface 301b, and to provide a pulling force to the fourth die 41 to debond the fourth die 41 from the third die 31.

In the embodiments of the present disclosure, after the fourth die 41 is aligned with the picking surface 301b of the bonding head 301, the bonding assembly drives the bonding head 301 to vertically move downward, until the picking surface 301b of the bonding head 301 contacts the fourth die 41 to re-pick the fourth die 41.

Exemplarily, the picking surface 301b of the bonding head 301 may include holes or free charges, so that the bonding head 301 may re-adsorb the fourth die 41 by vacuum adsorption or electrostatic adsorption. The fourth die 41 may include a bonding surface and a non-bonding surface arranged opposite to each other. When the re-picking operation is performed, the picking surface 301b re-picks the fourth die 41 by adsorbing the non-bonding surface of the fourth die 41.

Furthermore, the bonding assembly may use the mobile unit 308 to drive the bonding head 301 to vertically move upward in an arrow direction in FIG. 6, and allow the bonding head 301 to apply a pulling force to the fourth die 41, thereby generating an upward movement tendency. In response to the pulling force applied by the bonding head 301 on the fourth die 41 greater than Van Der Waals force between the fourth die 41 and the third die 31, the fourth die 41 is debonded from the third die 31.

It should be emphasized that the above operations debond the third die 31 and the fourth die 41 which have been bonded, when the first die 11 and the second die 21 are bonded. Furthermore, in the embodiments of the present disclosure, the first die 11 and the second die 21 which have been bonded may also be debonded when a next set of to-be-bonded dies are bonded.

Since Van Der Waals force is a microscopic force and has a relatively weak effect, the bonding assembly is used in the embodiments of the present disclosure, to apply the pulling force to the bonded dies, thereby achieving debonding between the die and the wafer. Debonding operation occurs before annealing operation, which is not only convenient and fast, but also may reduce loss of functional structures on the die, improving efficiency of bonding and reworking.

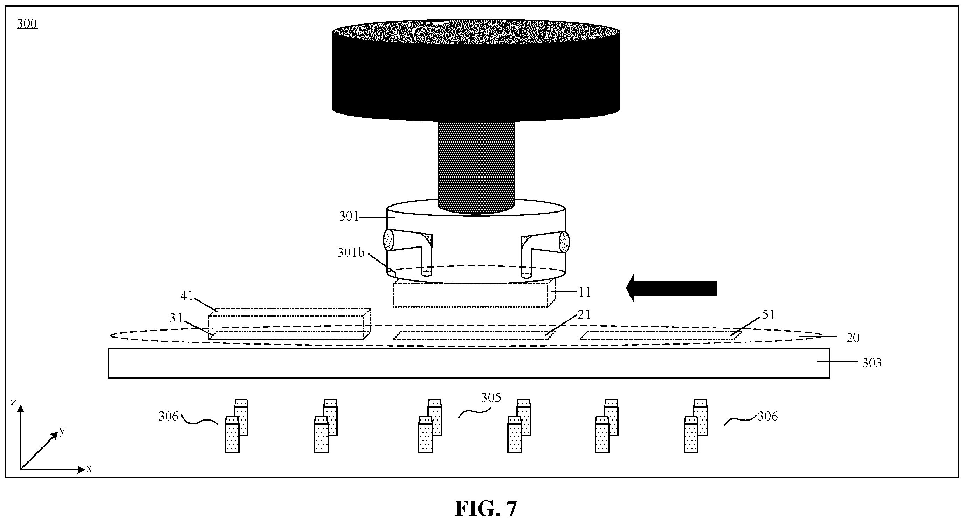

In some embodiments, with reference to FIG. 7, the bonding system 300 includes two sets of third alignment assemblies 306.

The two sets of third alignment assemblies 306 are located at adjacent positions on both sides of the second alignment assembly 305 respectively, here different third alignment assemblies 306 are used when the bonding assembly performs bonding along a first direction of distributing dies on the wafer 20 and when the bonding assembly performs bonding along a second direction of distributing dies on the wafer 20, and here the first direction and the second direction are opposite directions along a surface of the wafer 20.

With reference to FIG. 1, in the embodiments of the present disclosure, the wafer 20 may be distributed with a die array, that is, multiple dies distributed along the x-axis and y-axis directions and including the second die 21, the third die 31, or the like. During bonding external dies (such as the first die 11, the fourth die 41, or the like) to corresponding dies on the wafer 20 sequentially, the wafer stage 303 may be used to drive the wafer 20 to move in the x-axis or y-axis direction, to achieve alignment between dies, and then the bonding assembly may be used to drive the bonding head 301 to perform the bonding operation.

It should be emphasized that in the embodiments of the present disclosure, the second alignment assembly 305 is configured to determine the second deviation value between a current position of a to-be-bonded die (such as the second die 21 in FIG. 7) on the current wafer 20 and the second target position, to allow it to be aligned with a to-be-picked die (such as the first die 11 in FIG. 7). In the embodiments of the present disclosure, the third alignment assembly 306 is configured to determine the third deviation value between positions of dies (such as the third die 31 and the fourth die 41 in FIG. 7) which have been bonded, and then to determine whether debonding is required and reworking is performed.

With reference to FIG. 7, the wafer stage 303 drives the wafer 20 to move in an arrow direction in the figure, to sequentially align the third die 31 with the fourth die 41, align the first die 11 with the second die 21, and align a next to-be-picked die (not shown in the figure) with a next to-be-bonded die 51. Here, the arrow direction may be a negative direction of x-axis in a coordinate system. Therefore, two sets of third alignment assemblies 306 are located at adjacent positions on both sides of the second alignment assembly 305 in the x-axis direction respectively.

Exemplarily, multiple dies on the wafer 20 are distributed in the negative direction of x-axis sequentially, and are the next to-be-bonded die 51, the second die 21 and the third die 31 respectively. The third die 31 and the fourth die 41 have been bonded, and the first die 11 and the second die 21 are performing current alignment and bonding operations. Furthermore, the third alignment assembly 306 corresponding to the third die 31 is configured to detect whether the third die 31 and the fourth die 41 meet bonding conditions, and synchronously, the second alignment assembly 305 is configured to determine the second deviation value between the current position of the second die 21 and the second target position.

Exemplarily, after the third die 31 and the fourth die 41 meet bonding conditions, that is, the third deviation value is less than the preset threshold, and the first die 11 and the second die 21 have been bonded, the wafer stage 303 drives the wafer 20 to move by a certain distance in the negative direction of x-axis, so that the detection visual field of the second bonding assembly 305 covers a positioning mark on the next to-be-bonded die 51, to determine the second deviation value between a current position of the next to-be-bonded die 51 and the second target position. Synchronously, the bonding assembly may drive the bonding head 301 to re-pick a new to-be-picked die (not shown in the figure), and use the first alignment assembly to determine the first deviation value, to facilitate subsequent alignment and bonding operations. Here, the third alignment assembly 306 previously corresponding to the third die 31 may be configured to detect whether the first die 11 and the second die 21 meet bonding conditions.

Exemplarily, when the next to-be-bonded die 51 is the last die of the wafer 20 in this direction, it means that a row of dies on the wafer 20 has been bonded, and the wafer stage 303 is required to drive the wafer 20 to move by a certain distance in the y-axis direction, to continue bonding a next row of dies.

It may be understood that when the next row of dies is bonded, a bonding sequence changes from along the negative direction of x-axis to along the positive direction of x-axis, that is, the third die 31 and the fourth die 41 which have been bonded are located at a position of the next to-be-bonded die 51 in FIG. 7, and the third deviation value is determined by the third bonding assembly 306 corresponding to the next to-be-bonded die 51 in FIG. 7. The above operations are repeated until the batch of dies is bonded to the wafer 20 sequentially.

In the above embodiments, the first direction and the second direction are two opposite directions along the x-axis respectively.

In some other embodiments, two sets of third alignment assemblies 306 may be located at adjacent positions on both sides of the second alignment assembly 305 in the y-axis direction respectively. Here, the first direction and the second direction are two opposite directions along the y-axis respectively.

Therefore, in the embodiments of the present disclosure, bonding may be performed sequentially along the x-axis or y-axis direction of the die array distributed on the surface of the wafer 20. Usage of two sets of third alignment assemblies 306 may reduce a distance by which the wafer 20 moves, thereby saving operations, reducing displacement deviation and improving bonding accuracy.

In some embodiments, the third alignment assembly 306 and the second alignment assembly 305 are composed of a same set of lens components.

The lens component is configured to determine the second deviation value before bonding the first die 11 to the second die 21, and to determine the third deviation value after bonding the first die 11 to the second die 21.

In the embodiments of the present disclosure, similar to the first alignment assembly 304, the second alignment assembly 305 and the third alignment assembly 306 may also determine the second deviation value and the third deviation value through optical alignment respectively. Furthermore, optical alignment may be achieved by optical lenses, and optical lenses of the third alignment assembly 306 and the second alignment assembly 305 may be a same set of lens components with the same number, the same spacing, and positions corresponding to positioning marks.

Exemplarily, the set of lens components may include an optical transmitter configured to transmit a detection optical signal, such as a LED, a laser diode, or the like. The set of lens components may further include a photodetector configured to receive a reflection optical signal, such as a photodiode, a photomultiplier tube, or the like. Furthermore, the photodetector may be connected to an image sensor configured to convert the received reflection optical signal into a visual projection image.

It may be understood that the optical transmitter and the photodetector may also be integrated in the same lens component. Here, the detection optical signal transmitted by the optical transmitter covers positioning marks on the die, and in some embodiments, each of the positioning marks on the die may be provided with a respective one of the lens components correspondingly.

Exemplarily, with reference to FIG. 2A, bonding the first die 11 to the second die 21 is taken as an example. Before bonding the first die 11 to the second die 21, the second alignment assembly 305 transmits a detection optical signal to irradiate onto the positioning mark on the second die 21 to form a reflection optical signal, and the reflection optical signal is transmitted back to the second alignment assembly 305 to determine the second deviation value between the current position of the second die 21 and the second target position.

Furthermore, after bonding the first die 11 to the second die 21, the wafer stage 303 drives the wafer 20 so that the third alignment assembly 306 corresponds to the second die 21. Here, the first alignment assembly 304 determines the first deviation value between a current position of a next to-be-picked die and the first target position, and the second alignment assembly 305 determines the second deviation value between a current position of a next to-be-bonded die and the second target position. Synchronously, the third alignment assembly 306 is configured to determine the third deviation value between the first die 11 and the second die 21 which have been bonded.

Specifically, the third alignment assembly 306 transmits a detection optical signal (such as infrared light) to form reflection optical signals on positioning marks on the second die 21 and the first die 11 respectively. The reflection optical signal is transmitted back to the third alignment assembly 306, and then is converted into a visual projection image by an image sensor, so that the third deviation value between positions of the first die 11 and the second die 21 may be determined.

In the embodiments of the present disclosure, the alignment assembly composed of the same set of lens components may reduce operations and improve bonding efficiency.

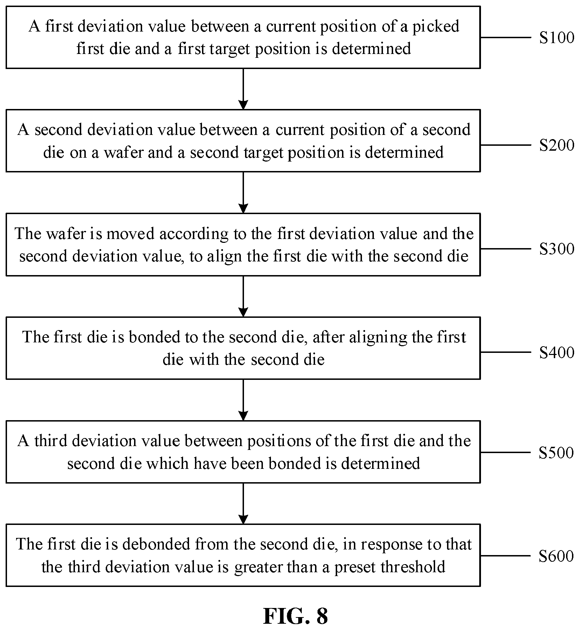

According to a second aspect of the embodiments of the present disclosure, with reference to FIG. 8, there is provided a bonding method. The bonding method includes the following operations S100-S600.

In operation S100, a first deviation value between a current position of a picked first die and a first target position is determined.

In operation S200, a second deviation value between a current position of a second die on a wafer and a second target position is determined.

In operation S300, the wafer is moved according to the first deviation value and the second deviation value, to align the first die with the second die.

In operation S400, the first die is bonded to the second die, after aligning the first die with the second die.

In operation S500, a third deviation value between positions of the first die and the second die which have been bonded is determined.

In operation S600, the first die is debonded from the second die, in response to that the third deviation value is greater than a preset threshold.

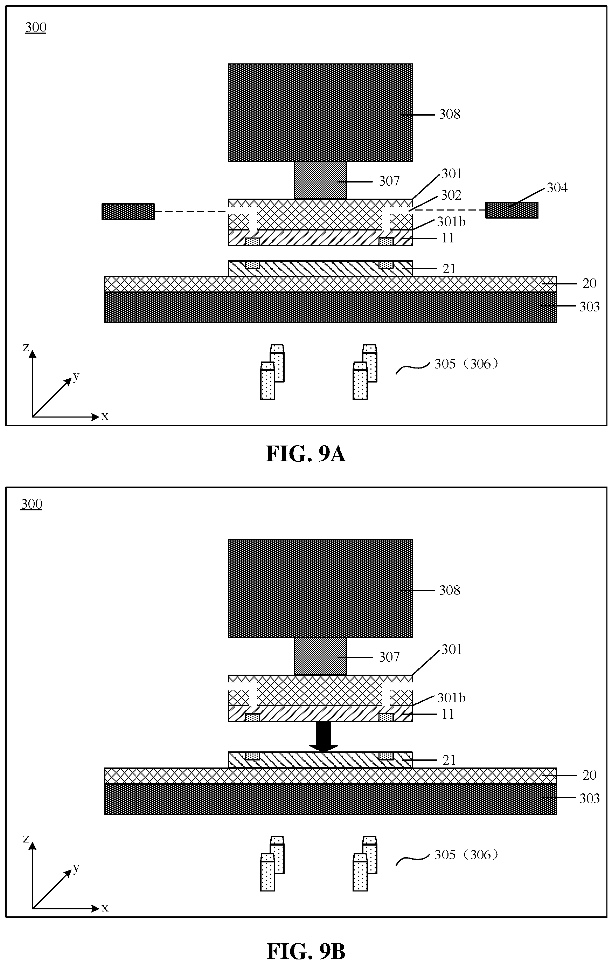

In operation S100, with reference to FIG. 2A, FIG. 2B and FIG. 9A, the first deviation value (Δx_{T}, Δy_{T}) between the current position (x₁, y₁) of the first die 11 and the first target position (x₀, y₀) may be determined by using the first alignment assembly 304, here Δx_{T} = x₁ - x₀, Δy_{T} = y₁ - y₀.

In operation S200, the wafer 20 is transmitted to the stage 303 after determining the first deviation value, and the second deviation value (Δx_{B}, Δy_{B}) between the current position (x₂, y₂) of the second die 21 on the wafer 20 and the second target position (x₀', y₀') may be determined by using the second alignment assembly 305, here Δx_{B} = x_{z} - x₀', Δy_{T} = y₂ - y₀'.

It should be pointed out that the first target position and the second target position have the same position in the horizontal direction, while have different positions in a vertical direction, that is, x₀ is the same as x₀', y₀ is the same as y₀', and the first target position and the second target position have different coordinates in the z direction. Different reference numerals are only intended to facilitate distinction between the first target position and the second target position, and are not intended to limit the present disclosure.

In operation S300, a displacement deviation between the first die 11 and the second die 21 may be determined to be (Δx_{T} - Δx_{B}, Δy_{T} - Δy_{B}) according to the first deviation value and the second deviation value. The bonding assembly may be kept fixed (that is, the first die 11 is kept fixed). The wafer stage 303 drives the wafer 20 to move by (Δx_{T} - Δx_{B}, Δy_{T} - Δy_{B}) horizontally according to the displacement deviation, so that the first die 11 is aligned with the second die 21, that is, positions of the first die 11 and the second die 21 in the horizontal direction are the same.

In operation S400, with reference to FIG. 2C and FIG. 9B, after aligning the first die 11 with the second die 21, the bonding assembly drives the bonding head 301 to vertically move downward, to bond the first die 11 to the second die 21.

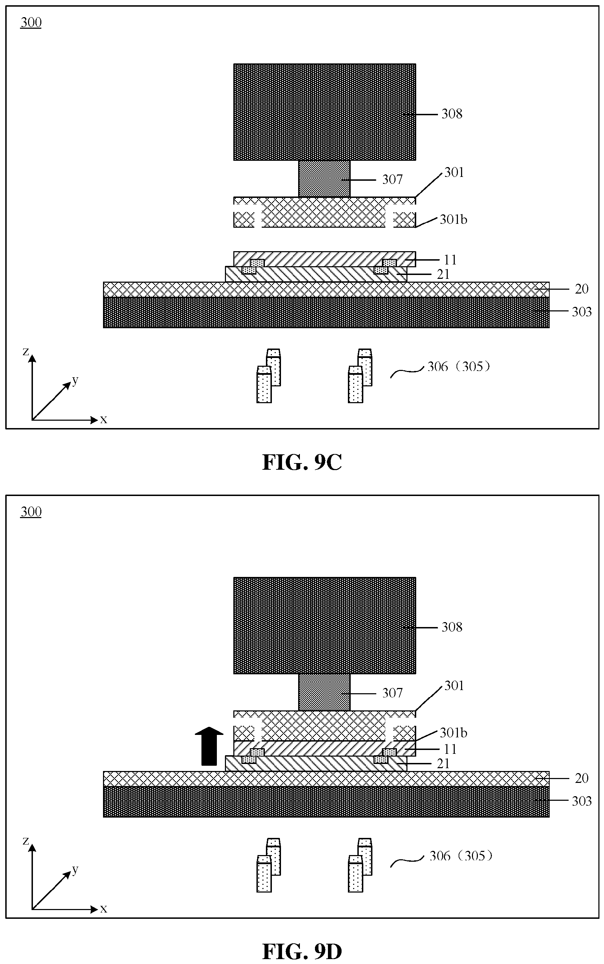

In operation S500, with reference to FIG. 2D and FIG. 9C, after bonding the first die 11 to the second die 21, the optical signal may be visualized as a projection image through optical alignment, and the third deviation value between the first die 11 and the second die 21 may be determined according to coordinates on the image, here the third deviation value is a horizontal displacement deviation.

In operation S600, with reference to FIG. 2F and FIG. 9D, in response to that the third deviation value is greater than the preset threshold, that is, in response to the horizontal displacement deviation between the first die 11 and the second die 21 greater than the preset threshold, the bonding assembly drives the bonding head 301 to apply a pulling force to the first die 11, thereby achieving debonding the die from the wafer.

In some embodiments, it may be determined whether the third deviation value between the first die 11 and the second die 21 is greater than the preset threshold, immediately after bonding the first die 11 to the second die 21. If yes, debonding is performed.

In some other embodiments, after bonding the first die 11 to the second die 21, the stage 303 may be moved to drive the wafer 20, to perform bonding operation on a next set of to-be-bonded dies. During bonding of the next set of to-be-bonded dies, it is determined whether the third deviation value between the first die 11 and the second die 21 is greater than the preset threshold. If yes, debonding the first die 11 from the second die 21 is performed after bonding of the next set of to-be-bonded dies is completed.

It should be emphasized that in the embodiments of the present disclosure, the first die 11 is a die independent of the wafer 20. In a process of manufacturing semiconductor devices, multiple dies are usually formed on the wafer 20. Here, the first die 11 refers to an independent die formed after the wafer 20 carrying multiple dies is cut. It may be understood that the first die 11 has a size much less than that of the wafer 20.

In the embodiments of the present disclosure, the first deviation value between the current position of the first die and the first target position, the second deviation value between the current position of the second die on the wafer and the second target position, and the third deviation value between positions of the first die and the second die which have been bonded are determined, and the first die is debonded from the second die, in response to that the third deviation value is greater than the preset threshold. In this way, it is convenient to timely rework dies with abnormal bonding, to improve yield rate of die to wafer bonding.

In some embodiments, the bonding method further includes the following operations after the first die is bonded to the second die.

The wafer is moved along a first direction, so that a next to-be-bonded die on the wafer and a picked next to-be-bonded die are located at opposite positions.

The operation of determining the third deviation value between positions of the first die and the second die which have been bonded is performed.

After performing operation S400, the wafer stage 303 drives the wafer 20 to move along a preset bonding direction, so that the first die 11 and the second die 21 which have been bonded move away, then a next set of to-be-bonded dies on the wafer is aligned with the next picked to-be-bonded die, and bonding operation continues.

Here, the next set of to-be-bonded dies on the wafer and the second die 21 may be adjacent dies on the wafer 20. During bonding operation of the next to-be-bonded die, operation S500 may be performed to determine the third deviation value between the first die 11 and the second die 21.

It should be emphasized that in the embodiments of the present disclosure, the first direction is a direction of actual bonding sequences. After bonding dies in the first direction sequentially, the first direction may be reversed, and bonding operation continues.

In some embodiments, debonding the first die from the second die, in response to that the third deviation value is greater than the preset threshold may include the following operations.

The wafer is moved along a second direction, in response to that the third deviation value is greater than the preset threshold, so that positions of the first die and the second die are located at a picking position, here the second direction is a direction opposite to the first direction, and the picking position is a corresponding position of a bonding head picking the first die.

The first die is debonded from the second die by using the bonding head picking the first die.

In operation S600, when it is detected that the third deviation value is greater than the preset threshold, the wafer stage 303 drives the wafer 20 to move along a direction opposite to the actual first direction, i.e., the second direction, to re-arrange the first die 11 and the second die 21 which have been bonded at corresponding positions of the bonding assembly. Here, the first direction is a direction of actual bonding sequences, and the second direction is a direction opposite to the actual bonding sequences.

Exemplarily, when the first direction is a positive direction of x-axis, the second direction is a negative direction of x-axis, and when the first direction is a positive direction of y-axis, the second direction is a negative direction of y-axis.

Furthermore, when the second die 21 is adjusted to be located at a position aligning with the picking surface 301b of the bonding head 301 again, the bonding assembly drives the bonding head 301 to apply a pulling force to the first die 11, thereby achieving debonding the die from the wafer.

In some embodiments, the bonding method further includes the following operations.

A fourth deviation value between a position of a third die adjacent to the second die on the wafer and a position of a fourth die bonded on the third die is determined, when the first die and the second die are located at opposite positions.

The third die is debonded from the fourth die, in response to that the fourth deviation value is greater than the preset threshold.

In the embodiments of the present disclosure, with reference to FIG. 3 to FIG. 7, when current to-be-bonded dies are the first die 11 and the second die 21, the third die 31 and the fourth die 41 which have been bonded previously may be detected to determine the fourth deviation value between positions of the third die 31 and the fourth die 41.

Similarly, here the fourth deviation value may also visualize the optical signal as a projection image through optical alignment and may be determined according to coordinates on the image.

In response to that the fourth deviation value is greater than the preset threshold, that is, in response to a horizontal displacement deviation between the third die 31 and the fourth die 41 greater than the preset threshold, the bonding assembly drives the bonding head 301 to apply a pulling force to the fourth die 41, thereby achieving debonding the die from the wafer.

It should be noted that features disclosed in several method or device embodiments provided in the present disclosure may be arbitrarily combined with each other without conflict, to obtain new method or device embodiments.

The above descriptions are only specific implementations of the present disclosure, however, the scope of protection of the present disclosure is not limited thereto. Variations or replacements easily conceived by any person skilled in the art within the technical scope disclosed in the present disclosure shall fall within the scope of protection of the present disclosure. Therefore, the scope of protection of the present disclosure shall be subject to the scope of protection of the claims.

## Claims

1. A bonding system, comprising:
a bonding assembly comprising a bonding head configured to pick a first die and a first optical path passing through the bonding head, wherein a first end of the first optical path is located at a picking surface where the bonding head picks the first die;
a wafer stage configured to carry a wafer;
a first alignment assembly located at a second end of the first optical path, and configured to determine a first deviation value between a current position of the first die and a first target position according to a detection optical signal transmitted in the first optical path;
a second alignment assembly located at a side of the wafer stage away from the bonding assembly, and configured to determine a second deviation value between a current position of a second die on the wafer and a second target position,
wherein the wafer stage further is configured to drive, according to the first deviation value and the second deviation value, the carried wafer to move relative to the picking surface, to align the second die with the first die;
the bonding assembly is further configured to bond the first die to the second die;
a third alignment assembly located at the side of the wafer stage away from the bonding assembly, and configured to determine a third deviation value between positions of the first die and the second die which have been bonded;
wherein the bonding assembly is further configured to debond the first die from the second die, in response to that the third deviation value is greater than a preset threshold.

2. The bonding system of claim 1, wherein
the third alignment assembly is located at a position adjacent to the second alignment assembly, and wherein when a detection visual field of the second alignment assembly covers the second die, a detection visual field of the third alignment assembly covers a third die adjacent to the second die, the third die is a die which has been bonded on the wafer, and the third die and a fourth die have been bonded.

3. The bonding system of claim 2, wherein
the wafer stage is further configured to move relative to the picking surface, in response to a fourth deviation value between positions of the third die and the fourth die greater than the preset threshold, to align the fourth die with the picking surface of the bonding assembly.

4. The bonding system of claim 3, wherein
the bonding assembly is further configured to pick the fourth die when the fourth die is aligned with the picking surface, and to provide a pulling force to the fourth die to debond the fourth die from the third die.

5. The bonding system of claim 2, further comprising:
two sets of third alignment assemblies located at adjacent positions on both sides of the second alignment assembly respectively, wherein different third alignment assemblies are used when the bonding assembly performs bonding along a first direction of distributing dies on the wafer and when the bonding assembly performs bonding along a second direction of distributing dies on the wafer, and wherein the first direction and the second direction are opposite directions along a surface of the wafer.

6. The bonding system of claim 1, wherein the third alignment assembly and the second alignment assembly are composed of a same set of lens components;
the lens component is configured to determine the second deviation value before the first die is bonded to the second die, and to determine the third deviation value after the first die is bonded to the second die.

7. A bonding method, comprising:
determining a first deviation value between a current position of a picked first die and a first target position;
determining a second deviation value between a current position of a second die on a wafer and a second target position;
moving the wafer according to the first deviation value and the second deviation value, to align the first die with the second die;
bonding the first die to the second die, after aligning the first die with the second die;
determining a third deviation value between positions of the first die and the second die which have been bonded; and
debonding the first die from the second die, in response to that the third deviation value is greater than a preset threshold.

8. The bonding method of claim 7, wherein the method further comprises:
after the first die is bonded to the second die, moving the wafer along a first direction, so that a next to-be-bonded die on the wafer and a picked next to-be-bonded die are located at opposite positions; and
performing the operation of determining the third deviation value between positions of the first die and the second die which have been bonded.

9. The bonding method of claim 8, wherein debonding the first die from the second die, in response to that the third deviation value is greater than the preset threshold comprises:
moving the wafer along a second direction, in response to that the third deviation value is greater than the preset threshold, so that positions of the first die and the second die are located at a picking position, wherein the second direction is a direction opposite to the first direction, and the picking position is a corresponding position of a bonding head picking the first die; and
debonding the first die from the second die by using the bonding head picking the first die.

10. The bonding method of any one of claims 7 to 9, further comprising:
determining a fourth deviation value between a position of a third die adjacent to the second die on the wafer and a position of a fourth die bonded on the third die, when the first die and the second die are located at opposite positions; and
debonding the third die from the fourth die, in response to that the fourth deviation value is greater than the preset threshold.
